# EUROPEAN PATENT APPLICATION

(11) **EP 2 128 845 A1**
(43) Date of publication of application: **02.12.2009**
(21) Application number: 08425378.0
(22) Date of filing: 26.05.2008
(51) Int. Cl.: G09F 9/33, G02B 27/01

(54) **Transparent display device with conductive paths provided with an opaque coating**

(71) Applicant: C.R.F. Società Consortile per Azioni, 10043 Orbassano (Torino) (IT)
(72) Inventor: Grasso, Valentina, 10043 Orabassano (Torino) (IT); Bernard, Stefano, 10043 Orabassano (Torino) (IT); Lambertini, Vito Guido, 10043 Orabassano (Torino) (IT); Antonipieri, Michele, 10043 Orabassano (Torino) (IT)
(74) Representative: Notaro, Giancarlo

(57) **Abstract**

A transparent display device, for example a "head-up" display for motor vehicles, comprises a substrate of transparent material (2), one or more light sources (4), for example in the form of chip-LEDs, applied to the said substrate (2), a plurality of conductive electrical paths (5) for providing a electrical supply to the light sources (4), applied onto the substrate (2), a transparent layer of synthetic resin (6) applied over the substrate (2), into which are incorporated the light sources (4) and the conductive paths (5), and an overlager (7) of transparent material applied over the layer of resin (6). At least some of the conductive paths (5) are covered with an opaque layer (8) which presents a substantial absorption in the visible spectrum, avoiding or substantially reducing reflection by the conductive paths of light rays coming from the light sources (4) which are propagated by reflection and refraction between the substrate and the overlager. In a variant, some portions of the conductive paths are left without the opaque layer (8), for the purpose of functioning as auxiliary light sources for illuminating depictions of symbols or icons which are formed on top of the transparent overlager.

## Description

The present invention refers to transparent display devices, for example "head-up" displays for motor vehicles, of the type comprising:
- a substrate of transparent material,
- one or more electrically supplied light sources, for example of the chip-LED type, applied onto the substrate,
- a plurality of electrically conductive paths for providing an electrical supply to said light sources, consisting of a non-transparent conducting material, applied onto said substrate,
- a transparent layer of synthetic resin applied over the substrate, into which are incorporated the light sources and the conductive paths, and
- an overlager of transparent material applied over the layer of resin.

In displays of the type specified above there is the problem of minimising the visibility of the conductive paths which are necessary for supplying the light sources. In some cases this problem is solved by employing a transparent conducting material for the conductive paths, such as for example ITO (Indium Tin Oxide). However, ITO is a material with a conductivity much lower than that of metals such as gold, silver or copper. For this reason, in order to supply the electrical voltage necessary for supplying the light source, the ITO path must have a width in the range of millimetres, much greater than the width of a metallic path, which is in the range of microns. The greater bulk of ITO paths, however, reduces the possible number of paths per unit of area, with a consequent reduction in the number of light sources and the total amount of information transmissible. For this reason, ITO, besides being expensive, is not usable when it is necessary to display a large quantity of information, in which case it is inevitably necessary to resort to conductive paths consisting of non-transparent metallic materials such as gold, silver or copper.

In the case of non-transparent conductive paths, the aim is to reduce to a minimum the visibility of such paths, by reducing their width to dimensions not larger than 20 microns. This solution does not avoid the disadvantage that light rays emitted by the light sources in the display which do not get out of the display but are propagated by reflection/refraction between the substrate and the overlager (through the layer of transparent resin), are reflected by the conductive paths and diffused by them to the outside.

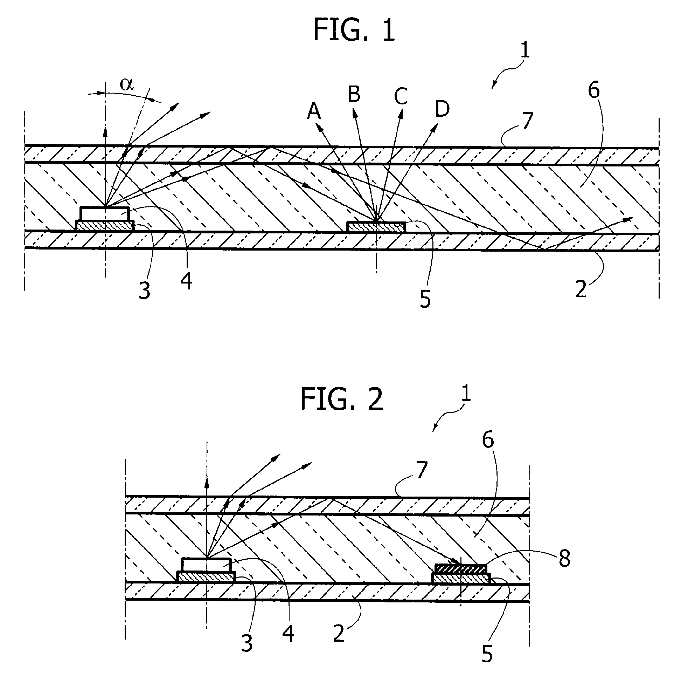

The above phenomenon is illustrated in figure 1 of the attached drawings, which shows a cross-sectional view of a display 1 according to the known art. Display 1 comprises substrate 2 of transparent material, for example glass or plastic, onto which are applied, by the interposition of metallic contacts 3, one or more light sources 4, for example in the form of chip-LEDs.

Also onto substrate 2 are applied conductive paths 5, for example made of gold, for the electrical supply to the various light sources 4. The light sources 4 and the paths 5 are embedded in a layer of transparent resin 6, over which is applied a transparent overlager 7 of glass or plastic. As can be seen in figure 1, the rays emitted by each light source 4 with an inclination α lower than a determined threshold angle (for example, in the order of 42°), are refracted to the outside of the display 1. Rays with an angle of inclination greater than the above threshold angle, on the other hand, are reflected, by total internal reflection, between the external surfaces of substrate 2 and overlager 7. These light rays are therefore propagated between surfaces 2 and 7, and when they encounter the upper surface of the conductive paths 5, are reflected by them. Since this surface is not a mirror-smooth surface, it gives rise to diffusion of the reflected light in several directions, A, B, C, D, thus making the paths 5 immediately visible and perceivable by the user.

The object of the present invention is to overcome this drawback.

With a view to the achievement of this object, the invention therefore provides a transparent display device having all the characteristics which have been indicated at the beginning of the present description and further **characterised in that** at least some of the conductive metallic paths are covered by an opaque layer which is such as to avoid or substantially reduce reflection, by the conductive paths, of light rays coming from the light sources which are propagated by reflection and refraction between the substrate and the overlager.

In the present description, and in the claims which follow, the expression "opaque layer" is intended to indicate a layer which presents a substantial absorption of the visible radiation.

The above-mentioned opaque coating consists, according to a first embodiment of the present invention, of a layer of metal oxide, for example copper oxide. In a second embodiment, the opaque layer consists of a layer of photoresist.

In a particularly interesting variant of the device according to the invention, only some of the conductive paths are covered with an opaque layer, while selected areas of other conductive paths are left free, and for this reason such zones become auxiliary light sources, which may be used, for example, for illuminating icons formed on the overlager of the display.

The invention also provides a method for the production of a transparent display device of the type described above, having the characteristics specified in claims 6 or 10.

Preferred embodiments of the method according to the invention are indicated in the claims dependent from claim 6.

Further characteristics and advantages of the invention will become clear from the description which follows with reference to the attached drawings, provided purely by way of non-limiting example, in which:
- figure 1, already discussed above, illustrates a cross-sectional view of a transparent display device according to the known art,
- figures 2 and 3 illustrate two embodiments of the display device according to the invention, and
- figures 4 and 5 are diagrams which illustrate the various stages of the method according to the invention, in two different embodiments.

In figure 2, the parts in common with figure 1 are indicated by the same reference number. The main difference in the device according to the invention in figure 2 by comparison with the device according to the known art illustrated in figure 1 consists in the fact that some or all of the conductive paths 5 are covered with an opaque layer 8 which eliminates or substantially reduces the reflection (by paths 5) of light rays coming from light sources 4, which actually strike the conductive paths 8 following propagation by total internal reflection between substrate 2 and overlager 7.

The opaque layer 8 is substantially absorbent in the visible spectrum and consists (for example) of a metal oxide (for example a copper oxide), or even (for example) of a layer of photoresist, obtained with a technique which will be explained in detail in the following. The colour of the opaque layer 8 is substantially dark, so as to tend to absorb the light energy which falls on it.

As a result of the above characteristic, in the display device according to the invention, the conductive paths 5, consisting of non-transparent conducting material, are substantially invisible to the user, since the phenomenon illustrated in figure 1, of reflection and diffusion of the light to the outside of display device 1 by conductive paths 5, is avoided.

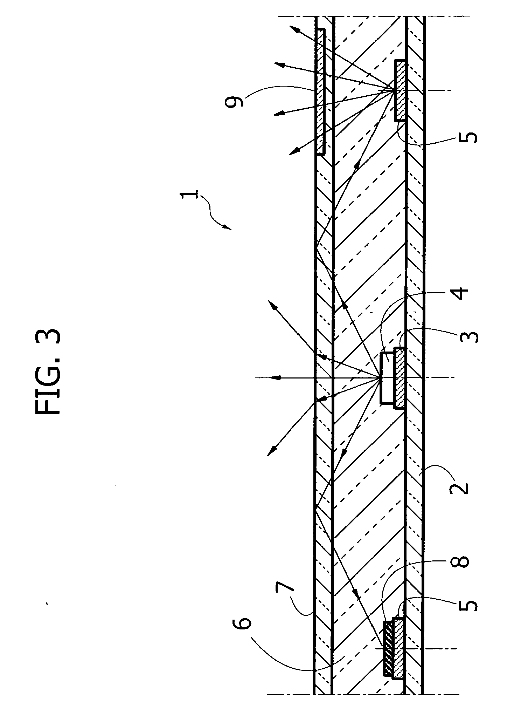

In a particularly important variant of the invention, illustrated in figure 3, provision is made for depictions 9 of symbols, icons or the like to be applied to overlager 7 by means of any known technique, these depictions being situated over portions of conductive paths 5. In the vicinity of these portions, the conductive paths should not be provided with the opaque layer 8. In this way, the majority of the extent of the conductive paths 5 is invisible to the user, because they are covered with the opaque layer 8, while the areas of the conductive paths which are located below the depictions 9 are not covered by the opaque layer, and for this reason they function as auxiliary light sources, for illuminating the depictions 9.

In a concrete embodiment, the thickness of the substrates 2 and 7 is approximately 1 mm. The layer 6 of transparent resin has a thickness in the order of several hundred microns. The metallic conductive paths 5 have a thickness in the order of several hundred nanometres and a width in the order of 20-100 microns. Opaque layer 8 has a thickness variable from a few hundred nanometres to several microns, depending on the material used.

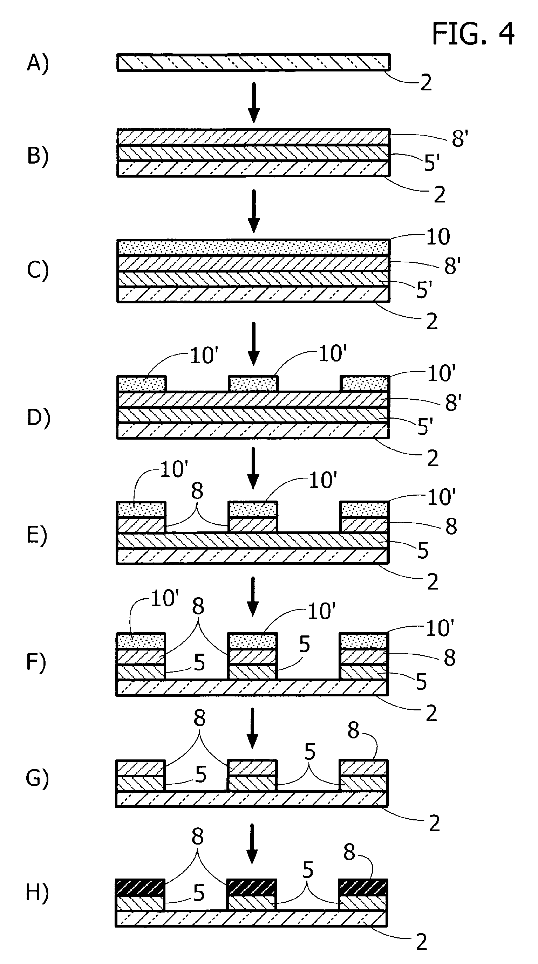

The procedure for the deposition of the opacifying material depends on the type of material used and on the process of making the transparent display. Generally, to obtain paths of a width below 100 microns, a photolithography procedure is used which, as may be seen in figure 4, provides for the preparation of the transparent substrate 2 (stage A), the application to it of a uniform layer 5' of conducting material, for example of gold (stage B), by means of a process of sputtering or evaporation, over the entire surface area of the transparent substrate 2. In the case of the method according to the invention, in the course of stage B a continuous layer 8' of metal, for example of copper, is applied over layer 5' of conducting metal. On top of the layers prepared as described above, a layer of photoresist 10 is then deposited (stage C). At this point, on top of photoresist layer 10 a mask is applied (not illustrated), which leaves exposed only certain areas of layer 10, after which these areas are removed as a result of exposure to UV radiation, so as to obtain portions of photoresist 10' arranged according a desired pattern (stage D). At this point, the residual portions 10' of photoresist are used as a mask to carry out a chemical etching operation, by means of which first the exposed portions of the layer of copper are removed (stage E), and then the exposed portions of the layer of gold (stage F).

In the case of the present invention, the subsequent removal of the layer of photoresist (stage G) leaves on transparent substrate 2 the conductive paths 5 and the portions of copper 8 which cover these paths. The portions of copper 8 are subjected to a process of oxidisation by heating in an oxygen-rich atmosphere, following which the surface of these layers 8 loses its sheen and becomes opaque to rays of light (stage H).

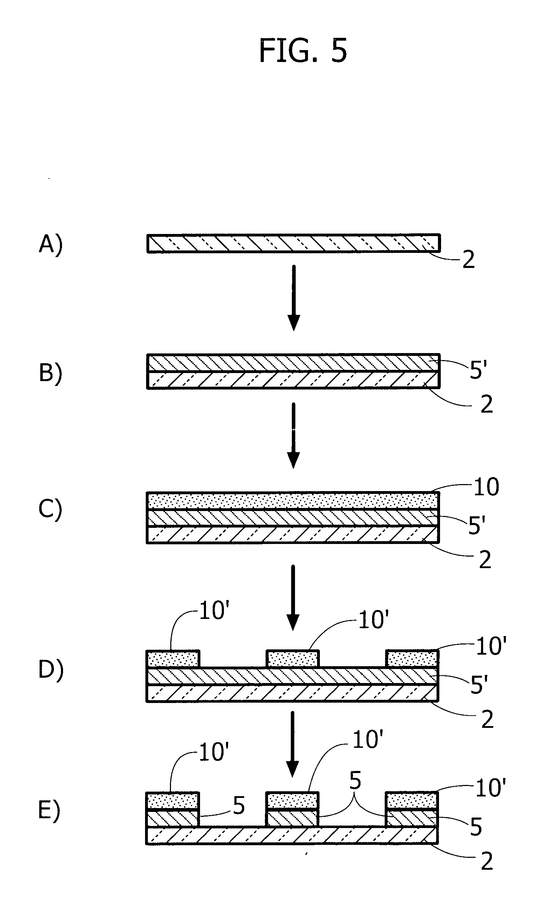

Figure 5 illustrates a particularly interesting variant of the method according to the invention, in which the deposition of the metallic layer 8' is omitted. Accordingly, after substrate 2 has been prepared (stage A), only the layer of conducting metal, for example gold, is deposited on it (stage B), and on this is deposited the photoresist layer (stage C). At this point, selected portions of the photoresist layer 10 are removed by exposing this layer to UV radiation, with the interposition of a mask (not illustrated) which enables the desired pattern to be obtained (stage D). Removal of the non-masked portions of gold is then carried out, by means of a process of chemical etching (stage E), so as to obtain the conductive paths 5 and the photoresist layers 10' applied onto them. These layers 10' are not removed and are used as opaque layers covering the conductive paths.

Naturally, the invention does not preclude the possibility of obtaining the device according to the invention through different techniques, such as for example by means of a silkscreening process, which however does not allow the conductive paths to go below 100 microns in width, because of the size of the mesh in the screens used in silkscreening, or for example by means of the deposition of thin lines of conductive and/or opacifying material using ink jet technology. This last technology is particularly interesting in the case of industrial production, possibly coupled with etching processes to reduce the width of the paths. In this case the opacifying materials used can be of oxidisable metallic type or generic polymers with a high opacification index and low speed of degradation once immersed in the resin which protects the circuitry and light sources in the display.

As is evident from the preceding description, the device according to the invention enables reflections on the conductive paths to be minimised, enables the uniformity of the light emission to be improved and enables the outgoing beam of light to be controlled, for example with solutions of the type illustrated in figure 3, as described above.

Naturally, without prejudice to the principle of the invention (?), the construction details and the embodiments can vary widely with respect to what has been described and illustrated, without for this reason departing from the scope of the present invention.

## Claims

1. A transparent display device, for example a "head-up" display for motor vehicles, comprising:
- a substrate (2) of transparent material,
- one or more electrically supplied light sources (4), for example of the chip-LED type, applied onto the substrate (2),
- a plurality of electrically conductive paths (5) for providing electrical supply to said light sources (4), consisting of a non-transparent conducting material, applied onto said substrate (2),
- a transparent layer (6) of synthetic resin applied over the substrate (2), into which the light sources (4) and the conductive paths (5) are incorporated, and
- a overlager (7) of transparent material applied over the resin layer (6),
said device being **characterised in that** at least some of the conductive paths (5) are covered with an opaque layer, or a layer which presents a substantial absorption in the visible spectrum (8), such as to avoid or substantially reduce reflection by the conductive paths (5) of light rays coming from said light sources (4) which are propagated by reflection and refraction between the substrate (2) and the overlager (7).

2. A device according to claim 1, **characterised in that** said opaque layer consists of a layer of metal oxide, for example copper oxide.

3. A device according to claim 1, **characterised in that** said opaque layer (8) consists of a layer of photoresist.

4. A device according to claim 1, **characterised in that** said opaque layer (8) consists of a layer of polymeric material.

5. A device according to claim 1, **characterised in that** some portions of the conductive paths (5) are lacking an opaque layer (8), so as to function as auxiliary light sources, for illuminating depictions of symbols or icons (9) which are formed on top of the transparent overlager (7).

6. A method for the production of a transparent display device, for example a "head-up" display for motor vehicles, comprising the stages of:
- preparing a substrate (2) of transparent material,
- applying over the substrate (2) of transparent material a uniform and continuous layer of non-transparent conducting material,
- applying a layer of photoresist over said layer of conducting material,
- exposing selected areas of said photoresist layer to UV radiation so as to remove portions of said photoresist layer and obtain a series of residual portions according to a desired pattern,
- carrying out an etching operation to remove the portions of the layer of conducting material not masked by the residual portions of photoresist,
- arranging on said transparent substrate (2) one or more electrically supplied light sources (4), for example in the form of chip-LEDs, using said residual portions (5) of the layer of conducting material as conductive paths for providing an electrical supply to said light sources,
- depositing a layer of synthetic transparent resin onto said substrate (2) so as to incorporate in it said conductive paths (5) and said light sources (4), and
- applying an overlager (7) of transparent material over said resin layer (6),
- said method being **characterised in that** over at least some of said conductive paths (5) an opaque layer (8) is arranged, which is such as to avoid or substantially reduce reflection by said conductive paths (5) of light rays coming from said light sources (4) which in the use of the device are propagated by reflection between the substrate (2) and the overlager (7).

7. A method according to claim 6, **characterised in that** said opaque layer (8) is obtained by arranging a continuous layer of metal (8'), for example copper, on said continuous layer of conducting material (5') before the application of the photoresist layer, in such a way that the subsequent etching operation effects the removal of portions of said metallic layer (8') together with portions of said layer of conducting material (5'), so as to obtain conductive paths (5) each covered with a metallic layer (8), said method comprising furthermore a stage of oxidisation of said metallic layer (8), achieved by means of heating in an oxygen-rich atmosphere.

8. A method according to claim 6, **characterised in that** the residual portions of the photoresist layer which remain on said conductive paths (5) after the removal of portions of said conducting layer (5') by means of the etching operation are left on the conductive paths and are made use of as opaque layers.

9. A method according to claim 6, **characterised in that** some portions of the conductive paths (5) are left lacking an opaque layer (8), so as to be able to be used as auxiliary light sources for illuminating depictions of symbols or icons (9) which are formed on top of the transparent overlager (7).

10. A method for obtaining a device according to claim 1, **characterised in that** the layer of opaque material is deposited using an ink-jet technique.
